# EUROPEAN PATENT SPECIFICATION

(11) **EP 0 324 819 B1**
(45) Date of publication and mention of the grant of the patent: **17.03.1993**
(21) Application number: 88905920.0
(22) Date of filing: 27.06.1988
(51) Int. Cl.: H01L 21/265

(54) **IMPROVED ION-IMPLANTED GaAs DEVICES**
IONENIMPLANTIERTE GAAS-BAUELEMENTE
DISPOSITIFS A L'ARSENIURE DE GALLIUM (GaAs) AMELIORE A IMPLANTATION IONIQUE

(30) Priority: 29.06.1987 GB 8715202; 08.03.1988 GB 8805464
(43) Date of publication of application: 26.07.1989
(73) Proprietor: GEC-MARCONI LIMITED, Stanmore, Middlesex HA7 4LY (GB)
(72) Inventor: BLUNT, Roy, Trevor, Northants NN7 3PJ (GB); STIRLAND, Derek, John, Northants NN12 8SB (GB)
(74) Representative: Pope, Michael Bertram Wingate
(86) International application number: GB8800497
(87) International publication number: WO8900336

(56) References cited:
- US-A- 4 391 651
- Patent Abstracts of Japan, volume 7, no. 200 (E-196)(1345), 3 September 1983, & JP, A, 5897828
- Institute of Physics Conference Series, no. 28, 1976, Chapter 2, B.J. Sealy et al.: "Dual-ion implantation into GaAs", pages 75-80 see pages 77-79; figure 1
- Journal of the Electrochemical Society, volume 132, no. 10, October 1985, (Manchester, New Hampshire, US), S.S. Chan et al.: "Redistribution and electrical properties of S implanted in GaAs", pages 2467-2472 see pages 2467-2469
- Nuclear Instruments and methods, volume 182/183, part2,April/May 1981, North-Holland Publishing Company, (Amsterdam, NL), J.P. Donnelly: "The Electrical characteristics of ion implanted compound semiconductors", pages 553-571
- Patent Abstracts of Japan vol 3, no. 22 (E-93), 24 February 1979, & JP, A, 54863
- Electronic Design, vol. 28, no. 10, May 1980, (Rochelle Park, US), S. Alderstein: "Processing discovery helps GaAs devices", pages 37-38

## Description

This invention relates to a method of manufacturing GaAs integrated circuit based on MESFET DEVICES.

An integrated circuit comprising a plurality of GaAs devices suffers from a disuniformity of characteristics such as threshold voltage from device to device upon the same GaAs substrate. It is believed that this disuniformity is due to crystal lattice dislocations in the substrate.

In any event, there is a tendency to localised disuniformity of doping level after ion implantation of a dopant. This gives rise to the above mentioned disuniformity of characteristics of the devices.

It is an object of the present invention to provide GaAs devices wherein the aforesaid disuniformity of device characteristics is minimised. Co-implantation of Groups IV and VI dopants in GaAs is known from US-A-4 391 651.

According to the present invention there is provided a method of manufacturing a GaAs integrated circuit including MESFET devices the method comprising forming an active layer on a surface of a Gallium Arsenide substrate by ion-implantation of a Group IV dopant and a Group VI dopant characterised in that the dose ratio of the ion-implanted group IV and group VI dopants is such that the stoichiometrically induced variation in activation of the group IV dopant is substantially equal and opposite to the stoichiometrically induced variation in activation of the group VI dopant to thereby produce approximately similar dopant implantation profiles and to thereby improve uniformity of threshold voltages of the MESFET devices across the circuit formed on said substrate.

Conveniently, the ion implantation energies of the dopants are arranged to produce similar implantation profiles.

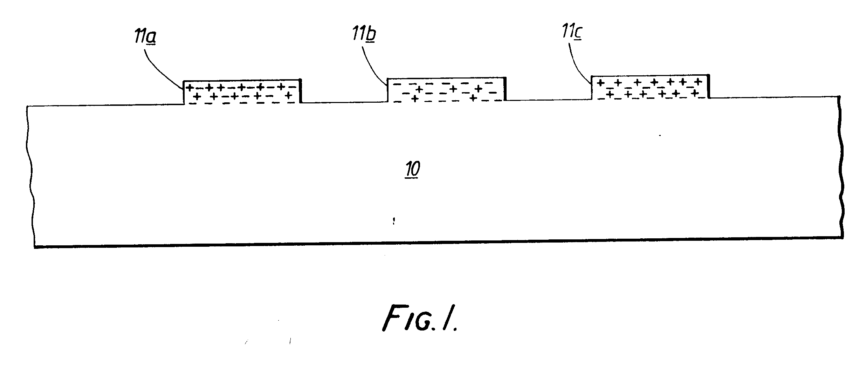

The invention will be described further, by way of example, with reference to the accompanying drawing wherein the single figure is a diagrammatic cross-section of part of a semi-conductor device formed on a Gallium Arsenide substrate.

One of the major problems in producing GaAs digital integrated circuits based on MESFET devices is that the uniformity of threshold voltage of the MESFETs across the circuit is not as good as for, say, the silicon MOS devices used in some silicon integrated circuits. Currently, the best uniformity of GaAs devices is obtained using ion implantation and annealing to fabricate the active layers. However, even in this case, there is extensive evidence that the local device threshold voltage depends on the proximity of the device to dislocation structures in the underlaying GaAs substrate. Considerable effort has been spent in attempts to establish the cause of this variation and the overall conclusion drawn is that it is due to local changes in stoichiometry of the substrate around groups of dislocations which cause small changes in the activation of implanted dopants, thus altering the threshold voltage. Such stoichiometrically induced variations in activation occur for virtually all implanted dopants in GaAs - the direction of the change in activation will depend upon both the change in stoichiometry (i.e. whether the region is Ga-rich or As-rich) and the site occupancy of the dopant. Thus a local excess of Ga will result in a decrease in activation of a group IV dopant (such as Si) which acts as a donor when on the Ga lattice, whilst a local excess of As will increase the activation of the same dopant. In contrast the opposite change in activation will occur for the group VI dopant (such as S or Se) which acts as a donor when on the As lattice. Because of these stoichiometrically induced alterations in dopant activation, it will be difficult to produce uniform activation (which would result in uniform threshold voltage devices) from single implants of any dopant species into GaAs substrates containing dislocations. However, if the active layer over the whole substrate is made by a co-implant of suitable group IV and group VI dopant (with implant energies adjusted to produce approximately similar profiles for each species), the stoichiometrically induced variation in activation of the group IV dopant would be partially compensated by an opposite change in activation of the group VI dopant thus resulting in a reduced overall change in total activation (and thus in threshold voltage). Correct choice of the dose ratio between the group IV and group VI dopants should result in near-zero influence of stoichiometry on device threshold voltages. Irrespective of where the device is formed on the substrate, the activation of the active layer is thereby equalised and the devices have more consistent threshold voltages.

Such as approach would have the advantage of giving improved uniformity and reproducibility of device threshold voltages for implants into any GaAs substrate, independent of the dislocation density or of overall stoichiometric differences in substrates, whilst still using readily available GaAs substrates and standard implantation, activation, and processing techniques.

As shown in the drawing, a Gallium Arsenide crystal lattice substrate 10 has an active layer 11 thereon. The layer 11 is formed by ion implantation of the substrate, in the particular region, of a dopant from Group IV of the periodic table of elements, i.e. a donor implant, in dependance upon the desired extent of activation required to produce a semi-conductor device or part of a device for incorporation into an integrated circuit on the substrate 10.

In accordance with the present invention, the active layer 11 is formed by implanting not only ions of a Group IV element but also ions of a Group VI element. Thus, localised increases, or decreases, in activation of the Group IV dopant are partially compensated by localised decreases, or increases, in activation of the Group VI dopant.

The layer 11 thus provides a donor region whose uniformity of activation is determined by the dose ratio of the implanted Group IV and Group VI ions, and whose activation level is determined by the total implanted dose

Alternative techniques which have been shown to give improved uniformity have involved the use of so-called "ingot annealed" GaAs substrates (where long term annealing has reduced local stoichiometric variations in the substrate) and the use of "low dislocation" or "dislocation free" wafers (where there are fewer dislocations to cause stoichiometric variations). The use of the proposed method of the present invention would improve device uniformities in the case of ingot annealed wafers and may also result in improvements in "low dislocation" wafers. The effect on true "dislocation free" wafers will be minimal, although there is a possibility that the variations already encountered in this material are due to localised stoichiometry changes resulting from causes other than dislocations. These variations also could be minimised by the dual implant procedure.

## Claims

1. A method of manufacturing a GaAs integrated circuit including MESFET devices, the method comprising forming an active layer on a surface of a Gallium Arsenide substrate by ion-implantation of a Group IV dopant and a Group VI dopant characterised in that the dose ratio of the ion-implanted group IV and group VI dopants is such that the stoichiometrically induced variation in activation of the group IV dopant is substantially equal and opposite to the stoichiometrically induced variation in activation of the group VI dopant to thereby produce approximately similar dopant implantation profiles and to thereby improve uniformity of threshold voltages of the MESFET devices across the circuit formed on said substrate.

2. A method as claimed in Claim 1, wherein the Group IV dopant is silicon.

3. A method as claimed in Claim 1 or 2, wherein the Group VI dopant is selenium.

## Patentansprüche

1. Verfahren zum Herstellen einer integrierten GaAs-Schaltung enthaltend MES-FET-Bauelemente, welches Verfahren die Bildung einer aktiven Schicht auf einer Oberfläche eines Galliumarsenid-Substrats durch Ionenimplantation eines Gruppe 4-Dotierungselements und eines Gruppe 6-Dotierungselements umfaßt,
**dadurch gekennzeichnet,**
daß das Dosisverhältnis der ionenimplantierten Gruppe 4- und Gruppe 6-Dotierungselemente derart ist, daß die stöchiometrisch induzierte Variation in der Aktivierung des Gruppe 4-Dotierungselements im wesentlichen gleich und entgegengesetzt zu der stöchiometrisch induzierten Variation in der Aktivierung des Gruppe 6-Dotierungselements ist, um dadurch annähernd ähnliche Dotierungselementimplantationsprofile zu erzeugen und um dadurch die Gleichförmigkeit der Schwellenspannungen der MESFET-Bauelemente der auf den Substrat ausgebildeten Schaltung zu verbessern.

2. Verfahren nach Anspruch 1, bei dem das Gruppe 4-Dotierungselement Silicium ist.

3. Verfahren nach Anspruch 1 oder 2, bei dem das Gruppe 6-Dotierungselement Selen ist.

## Revendications

1. Procédé de fabrication d'un circuit intégré sur GaAs comprenant des dispositifs de type MESFET (transistor métal-semi-conducteur à effet de champ), le procédé comprenant la formation d'une couche active sur une surface d'un substrat en arséniure de gallium, par implantation d'ions d'un dope du groupe IV et d'un dope du groupe VI, procédé caractérisé en ce que le rapport entre les doses des dopes de groupe IV et de groupe VI implantées sous forme d'ions est tel que la variation, provoquée par la stoéchiométrie, d'activation du dope de groupe IV est sensiblement égale et opposée à la variation, induite par la stoéchiométrie, d'activation du dope de groupe VI afin de produire ainsi des profils d'implantation de dopes sensiblement similaires et d'améliorer ainsi l'uniformité des seuils de tension électrique des dispositifs de type MESFET sur la totalité du circuit formé sur ledit substrat.

2. Procédé tel que revendiqué à la revendication 1, dans lequel le dope de groupe IV est le silicium.

3. Procédé tel que revendiqué à la revendication 1 ou 2, dans lequel le dope de groupe VI est du sélénium.
